# EUROPÄISCHE PATENTSCHRIFT

(11) **EP 2 891 161 B1**
(45) Veröffentlichungstag und Bekanntmachung des Hinweises auf die Patenterteilung: **12.09.2018**
(21) Anmeldenummer: 13742462.8
(22) Anmeldetag: 31.07.2013
(51) Int. Cl.: H02M 3/155, H02M 1/08, H01F 7/18

(54) **VERFAHREN ZUM REGELN DER STROMSTÄRKE DES DURCH EINEN INDUKTIVEN VERBRAUCHER FLIEßENDEN ELEKTRISCHEN STROMS SOWIE ENTSPRECHENDE SCHALTUNGSANORDNUNG**
METHOD FOR THE CLOSED-LOOP CONTROL OF THE CURRENT INTENSITY OF THE ELECTRICAL CURRENT FLOWING THROUGH AN INDUCTIVE CONSUMER AND CORRESPONDING CIRCUIT ARRANGEMENT
PROCÉDÉ DE RÉGULATION DE L'INTENSITÉ DU COURANT ÉLECTRIQUE CIRCULANT DANS UNE CHARGE INDUCTIVE, ET CIRCUIT CORRESPONDANT

(30) Priorität: 27.08.2012 DE 102012215155
(43) Veröffentlichungstag der Anmeldung: 08.07.2015
(73) Patentinhaber: Robert Bosch GmbH, 70442 Stuttgart (DE)
(72) Erfinder: LAMMERS, Christian, 70499 Stuttgart (DE); LEIBBRAND, Beate, 75417 Muehlacker (DE); HERRMANN, Alexander, 70191 Stuttgart (DE); REINHARDT, Steffen, 75173 Pforzheim (DE); GUENTHER, Uwe, 71154 Nufringen (DE); Wieja, Thomas, 72810 Gomaringen (DE); KLEIN, Christian, 71739 Oberriexingen (DE); MARTINI, Marco, 72766 Reutlingen (DE); SCHWARZMANN, Dieter, 74081 Heilbronn (DE); MUELLER, Bernd, 72766 Reutlingen (DE)
(86) Internationale Anmeldenummer: PCT/EP2013/066058
(87) Internationale Veröffentlichungsnummer: WO 2014/032893

(56) Entgegenhaltungen:
- WO-A1-2006/037715
- DE-A1-102007 028 344
- GARCIA CARLOS E ET AL: "INTERNAL MODEL CONTROL - 1. UNIFYING REVIEW AND SOME NEW RESULTS.", INDUSTRIAL & ENGINEERING CHEMISTRY, PROCESS DESIGN AND DEVELOPMENT, Bd. 21, Nr. 2, April 1982 (1982-04), Seiten 308-323, XP002729305,
- JAEHONG KIM ET AL: "Inverter-Based Local AC Bus Voltage Control Utilizing Two DOF Control", IEEE TRANSACTIONS ON POWER ELECTRONICS, INSTITUTE OF ELECTRICAL AND ELECTRONICS ENGINEERS, USA, Bd. 23, Nr. 3, 1. Mai 2008 (2008-05-01), Seiten 1288-1298, XP011207332, ISSN: 0885-8993

## Beschreibung

Die Erfindung betrifft ein Verfahren zum Regeln der Stromstärke des durch einen induktiven Verbraucher fließenden elektrischen Stroms gemäß Anspruch 1 sowie eine Schaltungsanordnung mit einem Steuergerät zur Regelung der Stromstärke des durch einen induktiven Verbraucher fließenden elektrischen Stroms gemäß Anspruch 9. Vorteilhafte Ausführungsformen sind in den abhängigen Ansprüchen definiert.

### Stand der Technik

Der induktive Verbraucher ist beispielsweise ein Aktor oder dergleichen, welcher insbesondere in einem Getriebe eines Kraftfahrzeugs, beispielsweise einem automatischen Getriebe, zum Einsatz kommt. Zum Betreiben des Verbrauchers wird dieser mit elektrischem Strom beaufschlagt, wobei das Verhalten des Verbrauchers durch das Einstellen der Stromstärke beeinflusst werden kann. Der Verbraucher kann beispielsweise als Magnetventil vorliegen, bei welchem über die Stromstärke ein Durchströmungsquerschnitt für ein Fluid und mithin der Durchsatz des Fluids durch das Magnetventil einstellbar ist.
Zum Regeln der Stromstärke ist der Verbraucher mit der Schaltvorrichtung und der Strommesseinrichtung in Reihe geschaltet. Die Schaltvorrichtung dient dazu, den Verbraucher entweder mit elektrischem Strom zu beaufschlagen oder die Stromzufuhr zu unterbrechen. Dies erfolgt unter Verwendung eines Pulsweitenmodulationsverfahrens, sodass die Schaltvorrichtung entsprechend zum Einstellen der Stromstärke während einer Pulsweitenmodulationsperiode beziehungsweise einer Vielzahl von aufeinander folgenden Pulsweitenmodulationsperioden angesteuert wird. Das Ansteuern erfolgt dabei mit einem bestimmten Tastverhältnis, welches angibt, über welchen zeitlichen Anteil der jeweiligen Pulsweitenmodulationsperiode der Verbraucher mit dem elektrischen Strom beaufschlagt werden soll.

Bei einem Tastverhältnis von Null erfolgt beispielsweise keinerlei Beaufschlagung des Verbrauchers, während bei einem Tastverhältnis von Eins das Beaufschlagen über die gesamte Pulsweitenmodulationsperiode hinweg erfolgt. Das Tastverhältnis wird üblicherweise individuell für jede Pulsweitenmodulationsperiode festgelegt. Selbstverständlich ist jedes beliebige Tastverhältnis von Null bis Eins wählbar, sodass der Anteil der Pulsweitenmodulationsperiode, während welchem der Verbraucher mit dem elektrischen Strom beaufschlagt wird, beliebig eingestellt werden kann. Entsprechend kann auch das Verhalten des Verbrauchers beliebig beeinflusst werden.

Die Strommesseinrichtung dient dazu, den tatsächlich durch den Verbraucher fließenden elektrischen Strom beziehungsweise dessen Stromstärke festzustellen, insbesondere durch Messen. Die Strommesseinrichtung umfasst dabei beispielsweise einen sogenannten Shunt-Widerstand. Aus der über diesen abfallenden Spannung kann auf die Stromstärke des durch den Verbraucher sowie den Shunt-Widerstand fließenden elektrischen Stroms geschlossen werden. Parallel zu dem Verbraucher liegt üblicherweise das Freilaufglied vor, welches beispielsweise als Freilaufdiode ausgebildet ist. Das Freilaufglied dient insbesondere dem Schutz des Verbrauchers vor Überspannungen, welche bei dem Unterbrechen der Stromversorgung des induktiven Verbrauchers mittels der Schaltvorrichtung vor allem bedingt durch Selbstinduktion auftreten können. Das Freilaufglied verhindert dabei das Auftreten von zu hohen Spannungen und damit eventuelle Beeinträchtigungen beziehungsweise Beschädigungen des induktiven Verbrauchers.

Insbesondere aufgrund der Selbstinduktion des induktiven Verbrauchers weist dieser ein hystereseartiges Verhalten auf, welches dazu führt, dass ein exaktes Einstellen der Stromstärke aufgrund von aus dem hystereseartigen Verhalten resultierenden Ungenauigkeiten nicht mehr ohne weiteres durchführbar ist, sodass die tatsächliche Stromstärke des durch den induktiven Verbraucher fließenden elektrischen Stroms nur näherungsweise eingestellt werden kann.

Aus dem Stand der Technik ist die Druckschrift DE 10 2007 028 344 A1 bekannt. Diese beschreibt ein Strommessmodul zum Messen eines Stroms durch eine Zumesseinrichtung für eine Common-Rail-Pumpe eines Einspritzsystems in einem Kraftfahrzeug, mit zwei Eingängen, welche an ein erstes Ende beziehungsweise ein zweites Ende eines Shuntwiderstands angeschlossen sind, der in Serie mit der Zumesseinheit verbunden ist und über welchen eine Shuntspannung abfällt, und einem Delta-Sigma-Modulater, welcher mit den zwei Eingängen verbunden ist und welcher die Shuntspannung in ein digitales Ausgangssignal umsetzt, dessen Mittelwert der Shuntspannung entspricht. Als weiterer Stand der Technik ist die Veröffentlichung "C. E. Carcia, M. Morari. Internal Model Control. 1. A Unifying Review and Some New Results. Int. Eng. Chem. Process Des. Dev., 21, 308-323, 1982" bekannt. Schließlich beschreibt die Druckschrift WO 2006/037715 A1 die Verwendung eines mit einem Dither-Signal überlagerten PWM-Signals zur Einstellung einer Zwischenstellung bei der Steuerung eines Magnetventils.

### Offenbarung der Erfindung

Das Verfahren mit den Merkmalen des Anspruchs 1 weist dagegen den Vorteil auf, dass das Regeln der Stromstärke des durch den induktiven Verbraucher fließenden elektrischen Stroms mit einer höheren Genauigkeit durchgeführt wird als aus dem Stand der Technik bekannte Verfahren. Dies wird erfindungsgemäß dadurch erreicht, dass aus einer Eingangsstromstärke mittels eines ersten Reglers eine in der Pulsweitenmodulationsperiode einzustellende mittlere Lastspannung bestimmt wird, die in der Pulsweitenmodulationsperiode mittels der Schaltvorrichtung an dem Verbraucher eingestellt wird, wobei einem an den Verbraucher angepassten Modell die mittlere Lastspannung oder eine aus einer vorgegebenen Sollstromstärke mittels eines zweiten Reglers bestimmte Solllastspannung zugeführt wird, wobei die Eingangsstromstärke aus der Differenz zwischen der vorgegebenen Sollstromstärke und einer Differenzgröße zwischen einer Iststromstärke durch den Verbraucher sowie einer mittels des Modells bestimmten Modellstromstärke ermittelt wird, und wobei die Sollstromstärke aus einer Vorgabestromstärke und einer Überlagerungsstromstärke bestimmt wird, wobei die Überlagerungsstromstärke aus einer Überlagerungsvorgabestromstärke mittels einer invertierten Übertragungsfunktion eines aus dem ersten Regler und dem Verbraucher bestehenden Regelkreises bestimmt wird. Es ist also insgesamt vorgesehen, das Regeln der Stromstärke mit Hilfe eines sogenannten IMC-Reglers (IMC: internal model control) vorzunehmen. Auf diese Weise wird die Parametrisierung des ersten Reglers vereinfacht, weil sie unmittelbar anhand der Eigenschaften des induktiven Verbrauchers erfolgt, insbesondere also aufgrund der Induktivität und des Widerstands des Verbrauchers. Entsprechend verringert sich der Applikationsaufwand des Systems.

Es ist zudem vorgesehen, dass mit Hilfe des ersten Reglers aus der Eingangsstromstärke nicht etwa unmittelbar das an der Schaltvorrichtung einzustellende Tastverhältnis ermittelt wird. Vielmehr soll zunächst eine einzustellende mittlere Lastspannung bestimmt werden. Das Tastverhältnis ist insbesondere abhängig von einer Versorgungsspannung einer über die Schaltvorrichtung an den Verbraucher angeschlossenen Stromversorgung. Zudem liegt eine Abhängigkeit des Tastverhältnisses von der Freilaufspannung des Freilaufglieds vor, die bei Unterbrechung der Stromversorgung des Verbrauchers mittels der Schaltvorrichtung Bedeutung erlangt. Die Versorgungsspannung der beispielsweise als Batterie beziehungsweise Akkumulator ausgebildeten Stromversorgung ist jedoch üblicherweise von dynamischen Störungen, also beispielsweise Spannungseinbrüchen oder Spannungssprüngen, überlagert. Würde nun der erste Regler unmittelbar das während der Pulsweitenmodulationsperiode einzustellende Tastverhältnis berechnen, so würden diese Störungen als Störgröße mit in den angewandten Regelalgorithmus einfließen.

Um den Einfluss der Störungen auf die Stabilität der Regelung zu begrenzen, müsste die dem ersten Regler zur Verfügung gestellte Information über die momentane Versorgungsspannung gefiltert werden, beispielsweise tiefpassgefiltert werden. Dies würde jedoch im Gegenzug dazu führen, dass Veränderungen der Versorgungsspannung nur mit einer durch die Filterung bedingten Verzögerung ausgeregelt werden könnten. Dies ist insbesondere bei Spannungssprüngen zu hohen Spannungen problematisch, weil durch diese der Verbraucher beschädigt werden könnte. Entsprechend ist es nun vorgesehen, lediglich die mittlere Lastspannung zu bestimmen, aus welcher in einem nächsten Schritt beispielsweise das Tastverhältnis ermittelt beziehungsweise welcher zum Ansteuern der Schaltvorrichtung herangezogen wird. Die mittlere Lastspannung entspricht der Spannung, die der erste Regler während der (nächsten) Pulsweitenmodulationsperiode an dem Verbraucher einstellen will, um die gewünschte Stromstärke zu erreichen.

Zur Umsetzung des IMC-Regelverfahrens liegt neben dem ersten Regler ein Modell des Verbrauchers vor, welcher analog zu der tatsächlichen Regelstrecke, nämlich dem Verbraucher, eine Stromstärke bereitstellt. Diese wird im Falle des Modells als Modellstromstärke bezeichnet. Die Modellstromstärke stellt die Ausgangsgröße, insbesondere die einzige Ausgangsgröße, des Modells dar. Als Eingangsgröße, insbesondere als einzige Eingangsgröße, wird dem Modell entweder die mittlere Lastspannung zugeführt, welche mit Hilfe des ersten Reglers bestimmt und auch während der Pulsweitenmodulationsperiode mittels der Schaltvorrichtung an dem Verbraucher eingestellt wird. Alternativ kann dem Modell auch eine Solllastspannung zugeführt werden, welche mittels des zweiten Reglers bestimmt wird. Diesem zweiten Regler wird als Eingangsgröße bevorzugt ebenso wie dem ersten Regler die Sollstromstärke zugeführt.

Um den den ersten Regler aufweisenden Regelkreis zu schließen, wird die ihm zugeführte Eingangsstromstärke aus einer Differenz bestimmt, bei welcher die Differenzgröße von der Sollstromstärke abgezogen wird. Die Differenzgröße liegt zwischen der Iststromstärke, welche beispielsweise mit Hilfe der Strommesseinrichtung bestimmt beziehungsweise gemessen wird, und der unter Anwendung des Modells erlangten Modellstromstärke vor. Die Differenzgröße ist beispielsweise die Differenz zwischen der Iststromstärke und der Modellstromstärke. Die Sollstromstärke ist die Stromstärke, welche an dem Verbraucher eingestellt werden soll. Bei einem idealen Modell, welches dem Verbraucher vollständig entspricht, und ohne das Auftreten von Störungen, ist die Differenzgröße somit stets gleich Null, sodass dem ersten Regler in diesem Fall die Sollstromstärke als Eingangsstromstärke beziehungsweise als Eingangsgröße zugeführt wird.

In einer Weiterbildung der Erfindung ist vorgesehen, dass die mittlere Lastspannung nach unten auf einen Minimalwert und/oder nach oben auf einen Maximalwert begrenzt wird. Anstelle oder zusätzlich zu der Begrenzung der mittleren Lastspannung kann auch eine Begrenzung des Betrags der mittleren Lastspannung vorgenommen werden. Mit Hilfe der Begrenzung nach unten wird sichergestellt, dass die Lastspannung beziehungsweise die mittlere Lastspannung nicht kleiner wird als eine minimal realisierbare Spannung. Alternativ oder zusätzlich kann die Begrenzung derart vorgenommen werden, dass die Lastspannung beziehungsweise die mittlere Lastspannung den Maximalwert nicht übersteigt. Auf diese Weise wird vor allem sichergestellt, dass die vorgegebene mittlere Lastspannung nicht größer wird als eine verfügbare Versorgungsspannung der Stromversorgung.

Entsprechend kann es in einer weiteren Ausgestaltung der Erfindung vorgesehen sein, dass als Maximalwert eine mittlere Versorgungsspannung einer Stromversorgung für den Verbraucher verwendet wird. Die Stromversorgung ist beispielsweise als Batterie beziehungsweise Akkumulator ausgebildet. Bedingt durch zu verschiedenen Zeitpunkten unterschiedliche Belastungen der Stromversorgung, insbesondere durch weitere Verbraucher, kann die Versorgungsspannung schwanken. Aus diesem Grund wird als Maximalwert bevorzugt nicht die Versorgungsspannung selbst, sondern ein Mittelwert, nämlich die mittlere Versorgungsspannung, verwendet. Die mittlere Versorgungsspannung wird beispielsweise durch ein Filtern der momentanen Versorgungsspannung, insbesondere mittels eines Tiefpassfilters, erlangt.

Zusätzlich oder alternativ kann vorgesehen sein, dass als Minimalwert eine Freilaufspannung oder der Betrag der Freilaufspannung des Freilaufglieds verwendet wird. Der Minimalwert wird somit durch die Eigenschaft des Freilaufglieds bestimmt und ist üblicherweise konstant, während der Maximalwert sich über der Zeit ändern kann.

Eine Weiterbildung der Erfindung sieht vor, dass aus der mittleren Lastspannung und der momentanen Versorgungsspannung der Stromversorgung wenigstens einmal während der Pulsweitenmodulationsperiode ein mittels der Schaltvorrichtung einzustellendes Tastverhältnis für die Pulsweitenmodulationsperiode bestimmt wird. Wie bereits vorstehend erläutert, wird die mittlere Lastspannung mit Hilfe des ersten Reglers ermittelt. Anhand der mittleren Lastspannung muss nachfolgend die Schaltvorrichtung angesteuert werden, um die gewünschte Stromstärke des durch den Verbraucher fließenden elektrischen Stroms einzustellen beziehungsweise zu regeln. Beispielsweise kann es vorgesehen sein, dass zu Beginn oder vor Beginn der Pulsweitenmodulationsperiode aus der mittleren Lastspannung das Tastverhältnis für die Pulsweitenmodulationsperiode festgelegt wird. Dabei kann neben der mittleren Lastspannung auch die momentane Versorgungsspannung der Stromversorgung einfließen. Alternativ ist selbstverständlich die Verwendung der mittleren Versorgungsspannung möglich.

Bei einer derartigen Vorgehensweise wird während der Pulsweitenmodulationsperiode die Schaltvorrichtung gemäß dem bestimmten Tastverhältnis eingestellt. Vorteilhafterweise wird jedoch das Tastverhältnis während der Pulsweitenmodulationsperiode mehrfach bestimmt beziehungsweise die Schaltvorrichtung derart angesteuert, dass sich ein bestimmtes Tastverhältnis einstellt. Dies erfolgt besonders bevorzugt anhand der momentanen Versorgungsspannung. Auf diese Weise können Schwankungen der Versorgungsspannung ausgeglichen werden, sodass sich diese nicht in einer Abweichung der Iststromstärke von der Sollstromstärke niederschlagen beziehungsweise das Regeln der Stromstärke negativ beeinflussen. Beispielsweise wird zu Beginn der Pulsweitenmodulationsperiode ein Zähler gleich Null gesetzt und während der Pulsweitenmodulationsperiode in aufeinander folgenden Arbeitstakten mit einer bestimmten Dauer um einen Wert inkrementiert, welcher der momentanen Versorgungsspannung dividiert durch die Dauer der (gesamten) Pulsweitenmodulationsperiode entspricht. Solange dieser Zähler kleiner ist als die mittlere Lastspannung, wird die Schaltvorrichtung zum Beaufschlagen des Verbrauchers mit elektrischem Strom angesteuert. Übersteigt dagegen der Zähler die mittlere Lastspannung, so wird die Schaltvorrichtung zum Unterbrechen der Stromversorgung angesteuert. Selbstverständlich sind auch analoge Vorgehensweisen möglich.

Eine weitere Ausgestaltung der Erfindung sieht vor, dass das Bestimmen der mittleren Lastspannung aus der Eingangsstromstärke mittels des ersten Reglers mit einer Pulsweitenmodulationsfrequenz erfolgt, und dass das Bestimmen des Tastverhältnisses mit einer Tastfrequenz erfolgt, wobei die Tastfrequenz größer als die Pulsweitenmodulationsfrequenz gewählt wird. Die Pulsweitenmodulationsfrequenz ergibt sich aus dem Kehrwert der Dauer der Pulsweitenmodulationsperiode. Die Pulsweitenmodulationsfrequenz ist vorzugsweise konstant, kann jedoch auch variabel gewählt werden. Wie bereits vorstehend erläutert, kann das Tastverhältnis während der Pulsweitenmodulationsperiode mehrfach bestimmt werden beziehungsweise die Schaltvorrichtung derart angesteuert werden, dass sich das bestimmte Tastverhältnis einstellt.

Die Tastfrequenz, mit welcher das Tastverhältnis während der Pulsweitenmodulationsperiode bestimmt wird beziehungsweise das Ansteuern der Schaltvorrichtung erfolgt, soll nun entsprechend größer sein als die Pulsweitenmodulationsfrequenz. Insbesondere ist sie deutlich größer, beispielsweise um den Faktor 2, 3, 4, 5, 10, 25 oder 50. Das Tastverhältnis wird mithin während der Pulsweitenmodulationsperiode an eine sich unter Umständen verändernde momentane Versorgungsspannung angepasst. So ist es möglich, bei der tatsächlichen Ansteuerung der Schaltvorrichtung die momentane Versorgungsspannung zu berücksichtigen und somit den Einfluss von Störungen auf diese deutlich zu reduzieren, ohne dass der erste Regler eingreifen muss. Entsprechend wird ein äußerst stabiler Regelkreis erzielt. Dabei kann es auch sinnvoll sein, die Freilaufspannung bei der Berechnung des Tastverhältnisses zu berücksichtigen.

In einer besonders bevorzugten Ausführungsform der Erfindung ist es vorgesehen, dass die Sollstromstärke aus einer Vorgabestromstärke und einer Überlagerungsstromstärke bestimmt wird, wobei die Überlagerungsstromstärke aus einer Überlagerungsvorgabestromstärke mittels einer invertierten Übertragungsfunktion eines aus dem ersten Regler und dem Verbraucher bestehenden Regelkreises bestimmt wird. Die Sollstromstärke, aus welcher schließlich die Eingangsstromstärke bestimmt wird, setzt sich also ihrerseits aus mehreren Werten, nämlich der Vorgabestromstärke und der Überlagerungsstromstärke, zusammen. Die Vorgabestromstärke beschreibt dabei beispielsweise diejenige Stromstärke, mit welcher ein gewünschter Zustand des Verbrauchers erzielt wird. Die Vorgabestromstärke ist insoweit eine mittlere Stromstärke, welche häufig über mehrere Pulsweitenmodulationsperioden konstant bleibt. Die Überlagerungsstromstärke ändert sich dagegen bevorzugt periodisch und entspricht insoweit einem Dither-Signal. Die Überlagerungsstromstärke wird beispielsweise anhand eines vorgegebenen Verlaufs über der Zeit bestimmt, welcher periodisch verläuft.
Die Sollstromstärke entspricht somit nicht der Vorgabestromstärke, sondern wird ausgehend von dieser vorzugsweise periodisch verringert oder vergrößert. Die Überlagerungsstromstärke ist dabei üblicherweise deutlich kleiner als die Vorgabestromstärke. Durch das Überlagern der Vorgabestromstärke mit der Überlagerungsstromstärke wird erreicht, dass ein bewegliches Element des induktiven Verbrauchers zu keinem Zeitpunkt stehen bleibt und entsprechend nicht in einen Bereich von Haftreibung übergeht. Vielmehr wird das Element stets in Bewegung gehalten, sodass es in einem Gleitreibungsbereich vorliegt. Auf diese Weise kann eine minimale Hysterese des Verbrauchers beziehungsweise des beweglichen Elements des Verbrauchers erzielt werden.

Die Überlagerungsstromstärke wird aus der Überlagerungsvorgabestromstärke berechnet, wobei sich letztere beispielsweise aus einer Tabelle oder anhand einer mathematischen Vorschrift, welche jeweils bevorzugt die Zeit oder eine äquivalente Größe als Parameter aufweisen, bestimmt wird. Auf die Überlagerungsvorgabestromstärke wird die invertierte Übertragungsfunktion angewandt, womit sich die Überlagerungsstromstärke ergibt. Die Übertragungsfunktion beschreibt den Regelkreis, der aus dem ersten Regler und dem Verbraucher besteht. Durch die Anwendung der invertierten Übertragungsfunktion wird sichergestellt, dass die Überlagerungsvorgabestromstärke tatsächlich an dem Verbraucher anliegt und nicht durch den ersten Regler oder sonstige Einflüsse verändert wird.
Grundsätzlich kann die Überlagerungsvorgabestromstärke über der Zeit beliebig verlaufen. Üblicherweise wechseln sich jedoch positive und negative Werte ab, sodass zunächst über eine bestimmte erste Anzahl von Pulsweitenmodulationsperioden ein positiver Wert und über eine nachfolgende Anzahl von Pulsweitenmodulationsperioden ein negativer Wert der Überlagerungsvorgabestromstärke vorliegt, wobei sich die Werte jeweils im positiven oder negativen Bereich in der Amplitude ändern kann. Die Anzahl der Pulsweitenmodulationsperioden kann dabei gleich oder auch verschieden sein. Ebenso kann die Amplitude der Überlagerungsvorgabestromstärke in den beiden Bereichen gleich oder verschieden gewählt sein. Stets ist dabei jedoch darauf zu achten, dass der Mittelwert über einer Periode der Überlagerungsvorgabestromstärke gleich 0 ist, sodass insoweit Mittelwertneutralität gegeben ist. Beispielsweise weist der Verlauf der Überlagerungsvorgabestromstärke einen sinusförmigen Verlauf auf.

Eine vorteilhafte Weiterbildung der Erfindung sieht vor, dass die Differenzgröße der, insbesondere durch ein Übertragungsglied geführten, Differenz zwischen der Iststromstärke durch den Verbraucher und der mittels des Modells bestimmten Modellstromstärke entspricht. Wie bereits vorstehend erläutert, kann die Differenzgröße gleich der Differenz zwischen der Iststromstärke und der Modellstromstärke sein, wobei letztere von ersterer abgezogen wird. Das Verwenden der Überlagerungsstromstärke beziehungsweise der Überlagerungsvorgabestromstärke kann dazu führen, dass sich die mittlere Stromstärke des durch den Verbraucher fließenden elektrischen Stroms - gemittelt über eine Periode der Überlagerungsvorgabestromstärke - verschiebt. Dieser Fall tritt insbesondere dann ein, wenn der Regelkreis, bestehend aus dem ersten Regler und dem Verbraucher, aufgrund der gewählten Zeitkonstanten, der Versorgungsspannung und/oder der Freilaufspannung nicht folgen kann. Der dabei entstehende Fehler wird als Mittelwertfehler bezeichnet und vorzugsweise ausgeregelt. Dabei wird das Verhalten des ersten Reglers genutzt, indem die Differenzgröße wie beschrieben zurückgeführt wird. Besonders vorteilhaft wird die Differenzgröße dabei durch das Übertragungsglied geführt.

Dieses Übertragungsglied kann beispielsweise ein P-Glied, ein I-Glied, ein D-Glied oder eine beliebige Kombination aus diesen sein.

Schließlich kann in einer weiteren Ausgestaltung der Erfindung vorgesehen sein, dass die Vorgabestromstärke, die Sollstromstärke und/oder die Eingangsstromstärke gefiltert werden. Mithin kann also eine einzelne der genannten Stromstärken oder mehrere, insbesondere alle, der genannten Stromstärken einer Filterung unterworfen werden. Auf diese Weise werden sprunghafte Änderungen der Stromstärken vermieden und die Stabilität der Regelung verbessert.

Die Erfindung betrifft weiterhin eine Schaltungsanordnung mit einem Steuergerät zur Regelung der Stromstärke des durch einen induktiven Verbraucher fließenden elektrischen Stroms, insbesondere eine Schaltungsanordnung zur Durchführung des vorstehend beschriebenen Verfahrens, wobei der Verbraucher mit einer Schaltvorrichtung und einer Strommesseinrichtung in Reihe und zu einem Freilaufglied parallel geschaltet ist und das Steuergerät dazu ausgebildet ist, die Schaltvorrichtung zum Einstellen der Stromstärke während einer Pulsweitenmodulationsperiode anzusteuern. Weiterhin ist das Steuergerät dazu vorgesehen, aus einer Eingangsstromstärke mittels eines ersten Reglers eine in der Pulsweitenmodulationsperiode einzustellende mittlere Lastspannung zu bestimmen, die in der Pulsweitenmodulationsperiode mittels der Schaltvorrichtung an dem Verbraucher eingestellt wird, wobei einem an den Verbraucher angepassten Modell die mittlere Lastspannung oder eine aus einer vorgegebenen Sollstromstärke mittels eines zweiten Reglers bestimmte Solllastspannung zugeführt wird, wobei die Eingangsstromstärke aus der Differenz zwischen der vorgegebenen Sollstromstärke und einer Differenzgröße zwischen einer Iststromstärke durch den Verbraucher sowie einer mittels des Modells bestimmten Modellstromsstärke ermittelt wird, und wobei die Sollstromstärke aus einer Vorgabestromstärke und einer Überlagerungsstromstärke bestimmt wird, wobei die Überlagerungsstromstärke aus einer Überlagerungsvorgabestromstärke mittels einer invertierten Übertragungsfunktion eines aus dem ersten Regler und dem Verbraucher bestehenden Regelkreises bestimmt wird. Auf die Vorteile einer derartigen Vorgehensweise wurde bereits hingewiesen. Die Schaltungsanordnung beziehungsweise das Verfahren kann selbstverständlich gemäß den vorstehenden Ausführungen weitergebildet sein, sodass insoweit auf diese verwiesen wird.

Die Erfindung wird nachfolgend anhand der in der Zeichnung dargestellten Ausführungsbeispiele näher erläutert, ohne dass eine Beschränkung der Erfindung erfolgt. Dabei zeigt:
- Figur 1: eine erste Ausführungsform einer Schaltungsanordnung,
- Figur 2: eine zweite Ausführungsform der Schaltungsanordnung,
- Figur 3: eine schematische Darstellung des mit Hilfe der Schaltungsanordnung umgesetzten Verfahrens in einer ersten Ausgestaltung,
- Figur 4: eine schematische Darstellung des Verfahrens in einer zweiten Ausgestaltung,
- Figur 5: eine Detailansicht eines Bereichs der Schaltungsanordnung in einer ersten Variante, und
- Figur 6: die Detailansicht der Schaltungsanordnung in einer zweiten Variante.

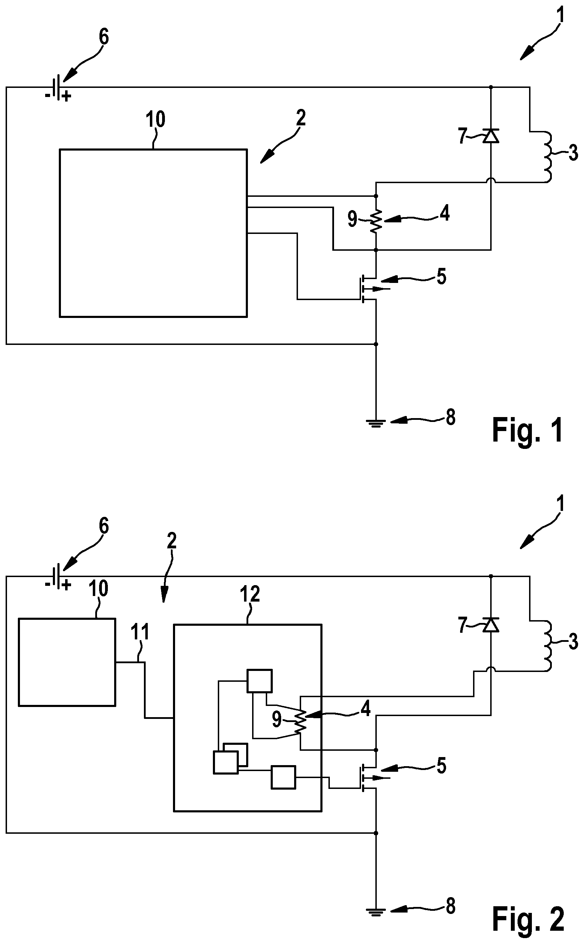

Die Figur 1 zeigt eine Schaltungsanordnung 1 mit einem Steuergerät 2, einem induktiven Verbraucher 3, einer Strommesseinrichtung 4 sowie einer Schaltvorrichtung 5. Zudem ist eine Stromversorgung 6 vorgesehen. An diese sind der Verbraucher 3, die Strommesseinrichtung 4 und die Schaltvorrichtung 5 gemeinsam angeschlossen, wobei sie zueinander in Reihe geschaltet sind. Zumindest parallel zu dem Verbraucher 3, bevorzugt jedoch zusätzlich parallel zu der Strommesseinrichtung 4 ist ein Freilaufglied 7 in Form einer Freilaufdiode geschaltet. Das Freilaufglied 7 ist mit seiner Kathode an einen Pluspol der Stromversorgung 6 angeschlossen, während seine Anode entweder zwischen dem Verbraucher 3 und der Strommesseinrichtung 4 oder (wie hier dargestellt) zwischen der Strommesseinrichtung 4 und der Schaltvorrichtung 5 angeschlossen ist. Der Verbraucher 3 liegt beispielsweise als Magnetventil beziehungsweise als Spule des Magnetventils vor.

Die Schaltvorrichtung 5 ist auf ihrer dem Verbraucher 3 abgewandten Seite auf eine Masse 8 gelegt. Dies ist jedoch optional. Sowohl die Strommesseinrichtung 4, welche beispielsweise einen Shunt-Widerstand 9 aufweist, als auch die Schaltvorrichtung 5, welche beispielsweise von einem Leistungselektronikschalter gebildet ist, sind an das Steuergerät 2 angeschlossen. Das Steuergerät 2, welches hier als Mikrocontroller 10 vorliegt, ermittelt mit Hilfe der Strommesseinrichtung 4 beziehungsweise des ShuntWiderstands 9 die Iststromstärke des durch den Verbraucher 3 fließenden elektrischen Stroms. Das Steuergerät 2 steuert zudem die Schaltvorrichtung 5 während einer Pulsweitenmodulationsperiode derart an, dass die Stromstärke beziehungsweise Iststromstärke geregelt wird.

Selbstverständlich kann die Schaltvorrichtung 5 anstelle der hier dargestellten Low-Side-Anordnung auch in einer High-Side-Anordnung, also auf der dem Pluspol der Stromversorgung 6 zugewandten Seite des Verbrauchers 3 angeordnet sein.

Die Figur 2 zeigt eine weitere Ausführungsform der Schaltungsanordnung 1. Der Unterschied zu der anhand der Figur 1 beschriebenen Ausführungsform liegt darin, dass der Mikrocontroller 10 nun lediglich über einen Bus 11 mit einer anwendungsspezifischen integrierten Schaltung (ASIC: application-specific integrated circuit) verbunden ist. Diese Schaltung 12 integriert die Strommesseinrichtung 4 sowie Mittel zum Ansteuern der Schaltvorrichtung 5. Zusätzlich ist es selbstverständlich möglich, beispielsweise die Schaltvorrichtung 5 ebenfalls in die Schaltung 12 zu integrieren. Zugleich kann die Schaltung 12 zum Regeln der Stromstärke für mehrere Verbraucher 3 ausgebildet sein, also insoweit mehrere Kanäle aufweisen. Weiterhin kann die Schaltung 12 zu Diagnosezwecken herangezogen werden. Schließlich ist es zudem möglich, den Mikrocontroller 10 in die Schaltung 12 zu integrieren.

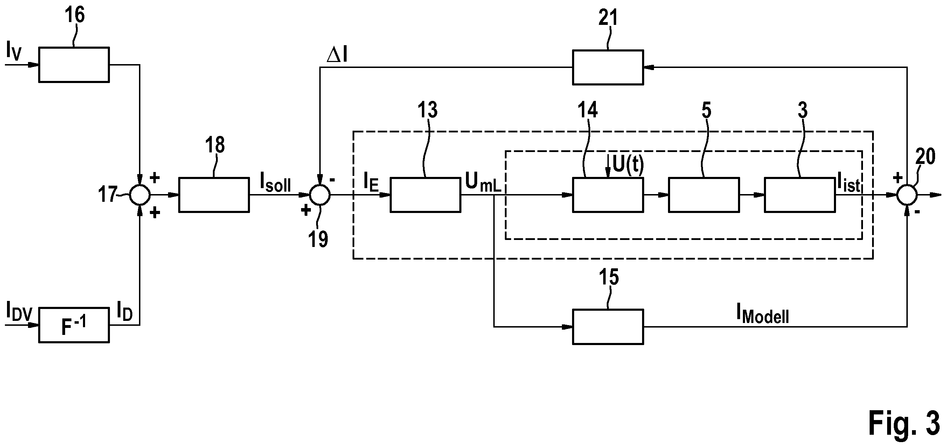

Die Figur 3 zeigt eine schematische Darstellung eines Verfahrens zum Regeln der Stromstärke des durch den Verbraucher 3 fließenden elektrischen Stroms, welches beispielsweise mittels der vorstehend genannten Schaltungsanordnung 1 beziehungsweise des Steuergeräts 2 umgesetzt wird. Dargestellt sind insbesondere der Verbraucher 3, die Schaltvorrichtung 5, ein erster Regler 13, ein weiterer Regler 14 sowie ein Modell 15. Als Eingangsgrößen dienen eine Vorgabestromstärke I_{V} sowie eine Überlagerungsvorgabestromstärke I_{DV}. Die Vorgabestromstärke I_{V} wird über einen Filter 16 geleitet und nachfolgend an einem Verknüpfungspunkt 17 bereitgestellt. Die Überlagerungsvorgabestromstärke I_{DV} wird mit Hilfe einer invertierten Übertragungsfunktion eines aus dem ersten Regler 13 und dem Verbraucher 3 bestehenden Regelkreises in eine Überlagerungsstromstärke I_{D} überführt. Diese wird ebenfalls an dem Verknüpfungspunkt 17 bereitgestellt. Dort wird sie zu der Vorgabestromstärke I_{V} addiert, sodass sich eine Sollstromstärke I_{Soll} ergibt, die nachfolgend beispielsweise über einen Filter 18 geführt wird.

Die Sollstromstärke I_{Soll} wird einem Verknüpfungspunkt 19 zugeführt, in welchem von ihr eine Differenzgröße ΔI subtrahiert wird. Aus dieser Subtraktion ergibt sich eine Eingangsstromstärke I_{E}, die als (insbesondere einzige) Eingangsgröße dem ersten Regler 13 zugeführt wird. Dieser erste Regler 13 ist bevorzugt als IMC-Regler ausgeführt und bestimmt aus der Eingangsstromstärke I_{E} eine mittlere Lastspannung U_{mL}. Diese wird als Eingangsgröße sowohl dem Regler 14 als auch dem Modell 15 jeweils als Eingangsgröße zur Verfügung gestellt. Dem Regler 14 wird zudem eine momentane Versorgungsspannung U(t) der Stromversorgung 6 zugeführt. Der Regler 14 bestimmt aus den ihm zugeführten Größen ein Tastverhältnis und steuert die Schaltvorrichtung 5 entsprechend an, sodass der Verbraucher 3 entweder mit Strom der Stromversorgung 6 beaufschlagt ist oder die Stromversorgung unterbrochen ist.

Die mit Hilfe der Strommesseinrichtung 4 beziehungsweise dem Shunt-Widerstand 9 bestimmte Iststromstärke I_{Ist} wird einem Verknüpfungspunkt 20 zugeführt. Parallel dazu berechnet das Modell 15, welches an den Verbraucher 3 beziehungsweise den Verbraucher 3 sowie die Schaltvorrichtung 5 angepasst ist, eine Modellstromstärke I_{Modell}. Diese wird ebenfalls dem Verknüpfungspunkt 20 zugeführt und dort von der Iststromstärke I_{Ist} subtrahiert. Das Ergebnis dieser Subtraktion stellt die Differenzgröße ΔI dar, welche optional über einen Filter 21, beispielsweise ein I-Glied, geführt wird. Durch das Zurückführen der Differenzgröße ΔI ist der Regelkreis geschlossen. Entsprechend können Störungen, die in der Regelstrecke, bestehend insbesondere aus dem Verbraucher 3 und der Schaltvorrichtung 5, auftreten, von dem ersten Regler 13 ausgeregelt werden.

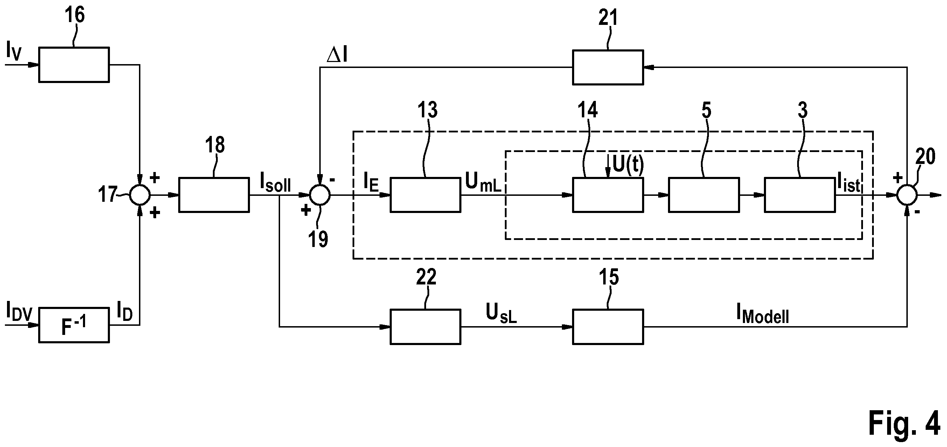

Die Figur 4 zeigt eine schematische Ansicht einer weiteren Ausgestaltung des aus der Figur 3 bekannten Verfahrens. Diese unterscheidet sich nun darin, dass dem Modell 15 nicht die mittels des ersten Reglers 13 bestimmte mittlere Lastspannung U_{mL} zugeführt wird. Vielmehr ist ein zweiter Regler 22 vorgesehen, dem die Sollstromstärke I_{Soll} als (vorzugsweise einzige) Eingangsgröße zugeführt wird. Aus dieser Sollstromstärke I_{Soll} bestimmt der zweite Regler 22 eine Solllastspannung U_{sL}, welche anstelle der mittleren Lastspannung U_{mL} dem Modell 15 zugeführt wird. Auf diese Weise kann beispielsweise der eingangs beschriebene Mittelwertfehler ausgeregelt werden. Es wird ausdrücklich darauf hingewiesen werden, dass die Filter 16, 18 und 21 in beiden Ausgestaltungen des Verfahrens optional sind, also nicht vorgesehen sein können.

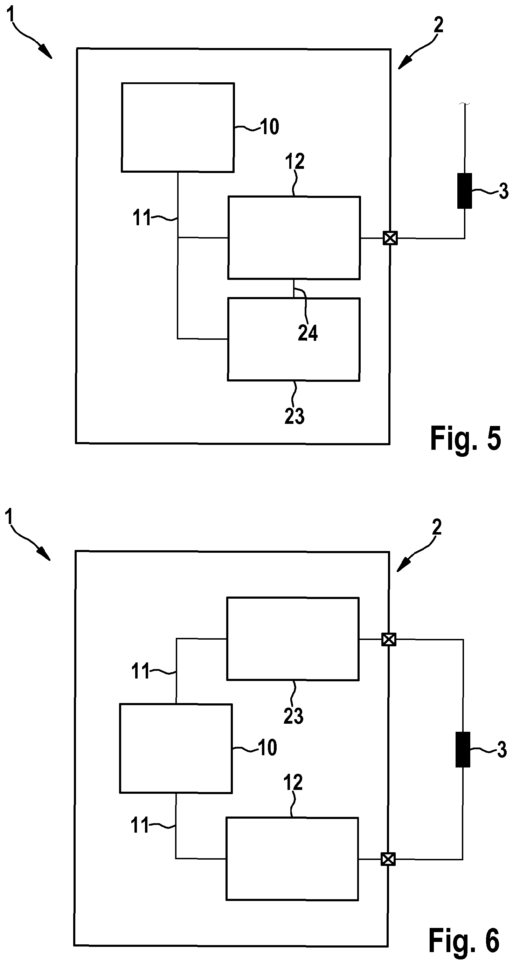

Die Figur 5 zeigt eine Detailansicht der Schaltungsanordnung 1 in einer ersten Variante, welche insbesondere auf die in der Figur 2 dargestellte Ausführungsform anwendbar ist. Dargestellt ist in schematischer Form der Verbraucher 3 und seine elektrische Verbindung zu der Schaltung 12. Diese ist ihrerseits auf bereits beschriebene Art und Weise mit dem Mikrocontroller 10 über den Bus 11 verbunden. Zusätzlich ist nun jedoch eine weitere Schaltung 23 vorgesehen, welche ebenfalls über den Bus 11 mit dem Mikrocontroller 10 verbunden ist. Zusätzlich kann eine weitere Verbindung 24 unmittelbar zwischen den Schaltungen 12 und 23 vorliegen. Auf diese Weise kann die Schaltung 23 zur Überwachung der Schaltung 12 verwendet werden, beispielsweise indem die Schaltung 23 ebenso wie die Schaltung 12 ein Ansteuersignal beziehungsweise ein Tastverhältnis für die Schaltvorrichtung 5 bestimmt. Die beiden auf diese Weise ermittelten Ansteuersignale beziehungsweise Tastverhältnisse werden nachfolgend miteinander verglichen und nur bei Übereinstimmung zur Ansteuerung der Schaltvorrichtung 5 und mithin zur Beaufschlagung des Verbrauchers 3 mit Strom aus der Stromversorgung 6 verwendet. Die Schaltungen 12 und 23 sind beispielsweise jeweils als ASIC ausgeführt.

Die Figur 6 zeigt eine Detailansicht der Schaltungsanordnung 1 in einer weiteren Variante, welche in sicherheitskritischen Bereichen Einsatz finden kann. Analog zu der in der Figur 5 dargestellten Variante, auf welche ausdrücklich verwiesen wird, sind nun zwei Schaltungen 12 und 23 vorgesehen. Die Schaltung 23 wird nun jedoch nicht lediglich zur Überwachung herangezogen, sondern ist ebenfalls elektrisch mit dem Verbraucher 3 verbunden. Die Schaltung 12 steuert dabei beispielsweise weiterhin die Schaltvorrichtung 5 an, während die Schaltung 23 eine hier nicht dargestellte weitere Schaltvorrichtung ansteuert. Erstere arbeitet mithin als Low-Side-Schalter für den Verbraucher 3, während letztere als High-Side-Schalter dient. Selbstverständlich ist jedoch auch eine umgekehrte Anordnung realisierbar. Die Schaltung 23 dient weiterhin der Überwachung der Schaltung 12 und ist während eines Normalbetriebs permanent durchgängig geschaltet. Wird nun jedoch ein Fehler der Schaltung 12 festgestellt, so kann die Beaufschlagung des Verbrauchers 3 mit elektrischem Strom mit Hilfe der Schaltung 23 unterbrochen werden.

Selbst bei einem Verharren der Schaltung 12 in einem Zustand, in welchem der Verbraucher 3 permanent mit der Masse 8 verbunden ist, kann also die Schaltung 23 die Stromversorgung des Verbrauchers 3 unterbrechen. Auf diese Weise wird eine Überwachung der Iststromstärke I_{Ist} beziehungsweise der Sollstromstärke I_{Soll} gemäß ASIL D realisiert. Ein solches ASIL D-System lässt sich auch mit lediglich einer Schaltung 12 realisieren, insbesondere wenn in der Schaltung 12 eine Erfassung des zum Ansteuern der Schaltvorrichtung 5 verwendeten Schaltsignals, also des PWM-Signals, integriert ist. In diesem Fall kann ein redundanter Überwachungspfad mit einer Diagnose basierend auf dem erfassten Schaltsignal realisiert werden. Hierbei werden Zustandsgrößen einer die Schaltungsordnung 1 aufweisenden Vorrichtung, beispielsweise eines Getriebes, ausgewertet. Derartige Größen sind beispielsweise die Getriebeöltemperatur oder der erwartete ohmsche Widerstand des Verbrauchers 3. Aus der Versorgungsspannung, dem erfassten Schaltsignal und dem errechneten Widerstand lässt sich eine zu erwartende Stromstärke des durch den Verbraucher 3 fließenden Stroms berechnen. Diese erwartete Stromstärke wird mit der Sollstromstärke I_{Soll} verglichen. Beim Auftreten eines Unterschieds, insbesondere eines Unterschieds, der einen bestimmten Grenzwert überschreitet, kann das Steuergerät 2 beziehungsweise die Schaltung 12 die Schaltvorrichtung 5 zum Unterbrechen der Stromversorgung des Verbrauchers 3 ansteuern.

Im Rahmen von allen vorstehend beschriebenen Ausführungsformen kann auf einfache Art und Weise eine Diagnose durchgeführt werden. Diese wird beispielsweise anhand wenigstens eines Zählers realisiert. Überschreitet der Fehler, beispielsweise pro Zeiteinheit, eine bestimmte Maximalfehleranzahl, so kann ein Fehlersignal gesetzt werden. Aufgrund dieses Fehlersignals können entsprechende Gegenmaßnahmen eingeleitet werden. Der Zähler wird beispielsweise inkrementiert, wenn während einer Pulsweitenmodulationsperiode eine Abweichung der Iststromstärke I_{Ist} von der Sollstromstärke I_{Soll} eine bestimmte Maximalabweichung überschreitet. Insbesondere wird ein dabei vorgesehener Vergleich zwischen der Iststromstärke I_{Ist} und der Sollstromstärke I_{Soll} genau einmal pro Pulsweitenmodulationsperiode durchgeführt.

## Patentansprüche

1. Verfahren zum Regeln der Stromstärke (I_{Ist}) des durch einen induktiven Verbraucher (3) fließenden elektrischen Stroms, wobei der Verbraucher mit einer Schaltvorrichtung (5) und einer Strommesseinrichtung (4) in Reihe und zu einem Freilaufglied (7) parallel geschaltet ist und die Schaltvorrichtung (5) zum Einstellen der Stromstärke (I_{Ist}) während einer Pulsweitenmodulationsperiode angesteuert wird, **dadurch gekennzeichnet, dass** aus einer Eingangsstromstärke (I_{E}) mittels eines ersten Reglers (13) eine in der Pulsweitenmodulationsperiode einzustellende mittlere Lastspannung (U_{mL}) bestimmt wird, die in der Pulsweitenmodulationsperiode mittels der Schaltvorrichtung (5) an dem Verbraucher (3) eingestellt wird, wobei einem an den Verbraucher (3) angepassten Modell (15) die mittlere Lastspannung (U_{mL}) oder eine aus einer vorgegebenen Sollstromstärke (I_{Soll}) mittels eines zweiten Reglers (22) bestimmte Solllastspannung (U_{sL}) zugeführt wird, wobei die Eingangsstromstärke (I_{E}) aus der Differenz zwischen der vorgegebenen Sollstromstärke (I_{Soll}) und einer Differenzgröße (ΔI) zwischen einer Iststromstärke (I_{Ist}) durch den Verbraucher (3) sowie einer mittels des Modells (15) bestimmten Modellstromstärke (I_{Modell}) ermittelt wird, und wobei die Sollstromstärke (I_{Soll}) aus einer Vorgabestromstärke (I_{V}) und einer Überlagerungsstromstärke (I_{D}) bestimmt wird, wobei die Überlagerungsstromstärke (I_{D}) aus einer Überlagerungsvorgabestromstärke (I_{DV}) mittels einer invertierten Übertragungsfunktion (F⁻¹) eines aus dem ersten Regler (13) und dem Verbraucher (5) bestehenden Regelkreises bestimmt wird.

2. Verfahren nach Anspruch 1, **dadurch gekennzeichnet, dass** die mittlere Lastspannung (U_{mL}) nach unten auf einen Minimalwert und/oder nach oben auf einen Maximalwert begrenzt wird.

3. Verfahren nach Anspruch 2, **dadurch gekennzeichnet, dass** als Maximalwert eine mittlere Versorgungsspannung einer Stromversorgung (6) für den Verbraucher (3) verwendet wird.

4. Verfahren nach einem der Ansprüche 2 oder 3, **dadurch gekennzeichnet, dass** als Minimalwert eine Freilaufspannung oder der Betrag der Freilaufspannung des Freilaufglieds (7) verwendet wird.

5. Verfahren nach einem der vorhergehenden Ansprüche, **dadurch gekennzeichnet, dass** aus der mittleren Lastspannung (U_{mL}) und einer momentanen Versorgungsspannung (U(t)) der Stromversorgung (6) wenigstens einmal während der Pulsweitenmodulationsperiode ein mittels der Schaltvorrichtung (5) einzustellendes Tastverhältnis für die Pulsweitenmodulationsperiode bestimmt wird.

6. Verfahren nach einem der vorhergehenden Ansprüche, **dadurch gekennzeichnet, dass** das Bestimmen der mittleren Lastspannung (U_{mL}) aus der Eingangsstromstärke (I_{E}) mittels des ersten Reglers (13) mit einer Pulsweitenmodulationsfrequenz erfolgt, und dass das Bestimmen des Tastverhältnisses mit einer Tastfrequenz erfolgt, wobei die Tastfrequenz größer als die Pulsweitenmodulationsfrequenz gewählt wird.

7. Verfahren nach einem der vorhergehenden Ansprüche, **dadurch gekennzeichnet, dass** die Differenzgröße (ΔI) der, insbesondere durch ein Übertragungsglied (21) geführten, Differenz zwischen der Iststromstärke (I_{Ist}) durch den Verbraucher (3) und der mittels des Modells (15) bestimmten Modellstromstärke (I_{Modell}) entspricht.

8. Verfahren nach einem der vorhergehenden Ansprüche, **dadurch gekennzeichnet, dass** die Vorgabestromstärke (I_{V}), die Sollstromstärke (I_{Soll}) und/oder die Eingangsstromstärke (I_{E}) gefiltert werden.

9. Schaltungsanordnung (1) mit einem Steuergerät (2) zur Regelung der Stromstärke des durch einen induktiven Verbraucher (3) fließenden elektrischen Stroms, insbesondere zur Durchführung des Verfahrens nach einem oder mehreren der vorhergehenden Ansprüche, wobei der Verbraucher (3) mit einer Schaltvorrichtung (5) und einer Strommesseinrichtung (4) in Reihe und zu einem Freilaufglied (7) parallel geschaltet ist und das Steuergerät (2) dazu ausgebildet ist, die Schaltvorrichtung (5) zum Einstellen der Stromstärke während einer Pulsweitenmodulationsperiode anzusteuern, **dadurch gekennzeichnet, dass** das Steuergerät (2) dazu vorgesehen ist, aus einer Eingangsstromstärke (I_{E}) mittels eines ersten Reglers (13) eine in der Pulsweitenmodulationsperiode einzustellende mittlere Lastspannung (U_{mL}) zu bestimmen, die in der Pulsweitenmodulationsperiode mittels der Schaltvorrichtung (5) an dem Verbraucher (3) eingestellt wird, wobei einem an den Verbraucher (3) angepassten Modell (15) die mittlere Lastspannung (U_{mL}) oder eine aus einer vorgegebenen Sollstromstärke (I_{Soll}) mittels eines zweiten Reglers (22) bestimmte Solllastspannung (U_{sL}) zugeführt wird, wobei die Eingangsstromstärke (I_{E}) aus der Differenz zwischen der vorgegebenen Sollstromstärke (I_{Soll}) und einer Differenzgröße (ΔI) zwischen einer Iststromstärke (I_{Ist}) durch den Verbraucher (3) sowie einer mittels des Modells (15) bestimmten Modellstromstärke (I_{Modell}) ermittelt wird, und wobei die Sollstromstärke (I_{Soll}) aus einer Vorgabestromstärke (I_{V}) und einer Überlagerungsstromstärke (I_{D}) bestimmt wird, wobei die Überlagerungsstromstärke (I_{D}) aus einer Überlagerungsvorgabestromstärke (I_{DV}) mittels einer invertierten Übertragungsfunktion (F⁻¹) eines aus dem ersten Regler (13) und dem Verbraucher (5) bestehenden Regelkreises bestimmt wird.

## Claims

1. Method for regulating the current intensity (I_{act}) of the electric current flowing through an inductive load (3), wherein the load is connected in series with a switching apparatus (5) and a current measuring device (4) and in parallel with a freewheeling element (7), and the switching apparatus (5) is actuated to set the current intensity (I_{act}) during a pulse width modulation period, **characterized in that** a mean load voltage (U_{mL}) to be set in the pulse width modulation period is determined from an input current intensity (I_{E}) by means of a first controller (13), said mean load voltage being set on the load (3) in the pulse width modulation period by means of the switching apparatus (5), wherein a model (15) matched to the load (3) is supplied with the mean load voltage (U_{mL}) or with a setpoint load voltage (U_{sL}) determined from a prescribed setpoint current intensity (Iₛₑₜₚₒᵢₙₜ) by means of a second controller (22), wherein the input current intensity (I_{E}) is ascertained from the difference between the prescribed setpoint current intensity (Iₛₑₜₚₒᵢₙₜ) and a difference variable (ΔI) between an actual current intensity (I_{act}) through the load (3) and a model current intensity (I_{model}) determined by means of the model (15), and wherein the setpoint current intensity (Iₛₑₜₚₒᵢₙₜ) is determined from a preset current intensity (Iv) and an overlay current intensity (I_{D}), wherein the overlay current intensity (I_{D}) is determined from an overlay preset current intensity (I_{DV}) by means of an inverted transfer function (F⁻¹) of a control loop consisting of the first controller (13) and the load (5).

2. Method according to Claim 1, **characterized in that** the mean load voltage (U_{mL}) is limited to a minimum value at the bottom and/or to a maximum value at the top.

3. Method according to Claim 2, **characterized in that** the maximum value used is a mean supply voltage of a power supply (6) for the load (3).

4. Method according to either of Claims 2 and 3, **characterized in that** the minimum value used is a freewheeling voltage or the absolute value of the freewheeling voltage of the freewheeling element (7) .

5. Method according to one of the preceding claims, **characterized in that** a duty ratio to be set by means of the switching apparatus (5) is determined for the pulse width modulation period from the mean load voltage (U_{mL}) and an instantaneous supply voltage (U(t)) of the power supply (6) at least once during the pulse width modulation period.

6. Method according to one of the preceding claims, **characterized in that** the mean load voltage (U_{mL}) is determined from the input current intensity (I_{E}) by means of the first controller (13) at a pulse width modulation frequency, and **in that** the duty ratio is determined at a sampling frequency, the sampling frequency being chosen to be greater than the pulse width modulation frequency.

7. Method according to one of the preceding claims, **characterized in that** the difference variable (ΔI) is consistent with the difference, in particular routed through a transmission element (21), between the actual current intensity (I_{act}) through the load (3) and the model current intensity (I_{model}) determined by means of the model (15) .

8. Method according to one of the preceding claims, **characterized in that** the preset current intensity (I_{V}), the setpoint current intensity (Iₛₑₜₚₒᵢₙₜ) and/or the input current intensity (I_{E}) are filtered.

9. Circuit arrangement (1) having a controller (2) for regulating the current intensity of the electric current flowing through an inductive load (3), in particular for performing the method according to one or more of the preceding claims, wherein the load (3) is connected in series with a switching apparatus (5) and a current measuring device (4) and in parallel with a freewheeling element (7), and the controller (2) is configured to actuate the switching apparatus (5) to set the current intensity during a pulse width modulation period, **characterized in that** the controller (2) is provided for the purpose of determining a mean load voltage (U_{mL}) to be set in the pulse width modulation period from an input current intensity (I_{E}) by means of a first controller (13), said mean load voltage being set on the load (3) in the pulse width modulation period by means of the switching apparatus (5), wherein a model (15) matched to the load (3) is supplied with the mean load voltage (U_{mL}) or with a setpoint load voltage (U_{sL}) determined from a prescribed setpoint current intensity (Iₛₑₜₚₒᵢₙₜ) by means of a second controller (22), wherein the input current intensity (I_{E}) is ascertained from the difference between the prescribed setpoint current intensity (Iₛₑₜₚₒᵢₙₜ) and a difference variable (ΔI) between an actual current intensity (I_{act}) through the load (3) and a model current intensity (I_{model}) determined by means of the model (15), and wherein the setpoint current intensity (Iₛₑₜₚₒᵢₙₜ) is determined from a preset current intensity (Iv) and an overlay current intensity (I_{D}), wherein the overlay current intensity (I_{D}) is determined from an overlay preset current intensity (I_{DV}) by means of an inverted transfer function (F⁻¹) of a control loop consisting of the first controller (13) and the load (5).

## Revendications

1. Procédé de régulation de l'intensité de courant (I_{réel}) du courant électrique circulant dans une charge inductive (3), dans lequel la charge est connectée en série à un dispositif de commutation (5) et à un dispositif de mesure de courant (4) et en parallèle à un composant de roue libre (7) et le dispositif de commutation (5) est excité pendant une période de modulation de largeur d'impulsion afin d'ajuster l'intensité de courant (I_{réel}),
**caractérisé en ce qu'**une tension de charge moyenne (U_{mL}) à ajuster dans la période de modulation de largeur d'impulsion est déterminée à partir d'une intensité de courant d'entrée (I_{E}) au moyen d'un premier régulateur (13), et est ajustée aux bornes de la charge (3) dans la période de modulation de largeur d'impulsion au moyen du dispositif de commutation (5), dans lequel un modèle (15) adapté à la charge (3) est alimenté avec la tension de charge moyenne (U_{mL}) ou une tension de charge théorique (U_{sL}) déterminée à partir d'une intensité de courant théorique (Iₜₕ) prédéterminée au moyen d'un deuxième régulateur (22),
dans lequel l'intensité de courant d'entrée (I_{E}) est déterminée à partir de la différence entre l'intensité de courant théorique (Iₜₕ) prédéterminée et une grandeur différentielle (ΔI) entre une intensité de courant réelle (I_{réel}) circulant dans la charge (3) et une intensité de courant de modèle (I_{mod}) déterminée au moyen du modèle (15), et dans lequel l'intensité de courant théorique (Iₜₕ) est déterminée à partir d'une intensité de courant prédéfinie (Iᵥ) et d'une intensité de courant de superposition (I_{D}), dans lequel l'intensité de courant de superposition (I_{D}) est déterminée à partir d'une intensité de courant prédéfinie de superposition (I_{DV}) au moyen d'une fonction de transfert inversée (F⁻¹) d'un circuit de régulation constitué du premier régulateur (13) et de la charge (5).

2. Procédé selon la revendication 1, **caractérisé en ce que** la tension moyenne de charge (U_{mL}) est limitée vers le bas à une valeur minimale et/ou vers le haut à une valeur maximale.

3. Procédé selon la revendication 2, **caractérisé en ce que** la valeur maximale utilisée est une tension d'alimentation moyenne d'une alimentation en courant (6) destinée à la charge (3).

4. Procédé selon l'une des revendications 2 ou 3, **caractérisé en ce que** la tension minimale utilisée est une tension de roue libre ou la valeur de la tension de roue libre de l'élément de roue libre (7).

5. Procédé selon l'une des revendications précédentes, **caractérisé en ce qu'**au moins une fois pendant la période de modulation de largeur d'impulsion, un rapport cyclique pour la période de modulation de largeur d'impulsion à ajuster est déterminé au moyen du dispositif de commutation (5) à partir de la tension de charge moyenne (U_{mL}) et d'une tension d'alimentation instantanée (U(t)) de l'alimentation en courant (6).

6. Procédé selon l'une des revendications précédentes, **caractérisé en ce que** la détermination de la tension de charge moyenne (U_{mL}) à partir de l'intensité de courant d'entrée (I_{E}) est effectuée au moyen du premier régulateur (13) avec une fréquence de modulation de largeur d'impulsion, et **en ce que** la détermination du rapport cyclique est effectuée avec une fréquence d'échantillonnage, dans lequel la fréquence d'échantillonnage est choisie de manière à ce qu'elle soit supérieure à la fréquence de modulation de largeur d'impulsion.

7. Procédé selon l'une des revendications précédentes, **caractérisé en ce que** la grandeur différentielle (ΔI) correspond à la différence, en particulier à travers un élément de transmission (21), entre l'intensité de courant réelle (I_{réel}) circulant dans la charge (3) et l'intensité de courant de modèle (I_{mod}) déterminée au moyen du modèle (15).

8. Procédé selon l'une des revendications précédentes, **caractérisé en ce que** l'intensité de courant prédéfinie (Iv), l'intensité de courant théorique (Iₜₕ) et/ou l'intensité de courant d'entrée (I_{E}) sont filtrées.

9. Système de circuit (1) comportant un dispositif de commande (2) pour la régulation de l'intensité du courant électrique circulant dans une charge inductive (3), en particulier pour la mise en oeuvre du procédé selon une ou plusieurs des revendications précédentes, dans lequel la charge (3) est connectée en série à un dispositif de commutation (5) et à un dispositif de mesure de courant (4) et en parallèle à un élément de roue libre (7) et le dispositif de commande (2) est conçu pour exciter pendant une période de modulation de largeur d'impulsion le dispositif de commutation (5) afin d'ajuster l'intensité du courant,
**caractérisé en ce que** le dispositif de commande (2) est prévu pour déterminer, à partir d'une intensité de courant d'entrée (I_{E}) au moyen d'un premier régulateur (13), une tension de charge moyenne (U_{mL}) à ajuster dans la période de modulation de largeur d'impulsion, qui est ajustée aux bornes de la charge (3) dans la période de modulation de largeur d'impulsion au moyen du dispositif de commutation (5),
dans lequel un modèle (15) adapté à la charge (3) est alimenté avec la tension de charge moyenne (U_{mL}) ou une tension de charge théorique (U_{sL}) déterminée à partir d'une intensité de courant théorique (Iₜₕ) prédéterminée au moyen d'un deuxième régulateur (22), dans lequel l'intensité de courant d'entrée (I_{E}) est déterminée à partir de la différence entre l'intensité de courant théorique (Iₜₕ) prédéterminée et une grandeur différentielle (ΔI) entre une intensité de courant réelle (I_{réel}) circulant dans la charge (3) et une intensité de courant de modèle (I_{mod}) déterminée au moyen du modèle (15) ; et dans lequel l'intensité de courant théorique (Iₜₕ) est déterminée à partir d'une intensité de courant prédéfinie (Iv) et d'une intensité de courant de superposition (I_{D}), dans lequel l'intensité de courant de superposition (I_{D}) est déterminée à partir d'une intensité de courant prédéfinie de superposition (I_{DV}) au moyen d'une fonction de transfert inversée (F⁻¹) d'un circuit de régulation constitué du premier régulateur (13) et de la charge (5).
